(19) **Europäisches Patentamt**

**European Patent Office**

**Office européen des brevets**

(11) **EP 0 949 761 B1**

(12) **FASCICULE DE BREVET EUROPEEN**

(45) Date de publication et mention
de la délivrance du brevet:
**03.03.2004 Bulletin 2004/10**

(51) Int Cl.$^7$: **H03K 19/096**, H03K 19/21

(21) Numéro de dépôt: **99400834.0**

(22) Date de dépôt: **06.04.1999**

(54) **Procédé et dispositif de traitement d'informations binaires**

Verfahren und Vorrichtung zur Bearbeitung von binären Daten

Method and device for processing binary data

(84) Etats contractants désignés:
**AT BE CH DE DK ES GB IE IT LI LU NL SE**

(30) Priorité: **06.04.1998 FR 9804252**

(43) Date de publication de la demande:
**13.10.1999 Bulletin 1999/41**

(73) Titulaire: **ETAT FRANCAIS Représenté par le Délégué Général pour l'Armement 00460 Armées (FR)**

(72) Inventeurs:
• **Paillet, Fabrice 91700 Villiers-sur-Orge (FR)**

• **Mercier, Damien 75013 Paris (FR)**
• **Bernard, Thierry 91370 Verrieres-le Buisson (FR)**

(56) Documents cités:
**FR-A- 2 683 348**

• **PATENT ABSTRACTS OF JAPAN vol. 012, no. 383 (P-770), 13 octobre 1988 (1988-10-13) & JP 63 127497 A (NEC CORP), 31 mai 1988 (1988-05-31)**
• **PATENT ABSTRACTS OF JAPAN vol. 017, no. 661 (E-1471), 7 décembre 1993 (1993-12-07) & JP 05 218850 A (NIPPON TELEGR & TELEPH CORP), 27 août 1993 (1993-08-27)**

**Description**

La présente invention telle que definie dans les revendications concerne le domaine des équipements de traitement de données comprenant éventuellement, dans certaines applications, telles les rétines artificielles, un ensemble d'unités de traitement à commandes communes.

L'utilisation d'unités de traitement, ou processeurs associées à des points mémoires semi-statiques, c'est-à-dire une structure en boucle fermée comprenant deux inverseurs installés dans le même sens de rotation, la sortie de l'un étant connectée à l'entrée de l'autre à travers un interrupteur, est décrite dans les brevets FR2583602 et FR2683348. Ces points mémoire semi-statiques présentent l'intérêt de pouvoir être chaînés simplement pour former des structures capables de déplacer les données, bien connues sous le nom de réseau (ou registre) à décalage semi-statique.

Le brevet FR2583602 décrit ainsi une rétine intégrée à réseau de processeurs. Cette rétine est constituée par un réseau de cellules formées sur un substrat. Chaque cellule comprend un élément photosensible fournissant un signal représentatif de la valeur d'un élément d'une image formée sur la rétine, un élément de conversion de ce signal en une information binaire, des moyens de mémorisation de cette information, et un processeur élémentaire. Les moyens de mémorisation sont organisés en réseau bidimensionnel de registres à décalage permettant ainsi le transfert de l'information d'une cellule à une cellule voisine quelconque. Les registres à décalage ainsi que les processeurs sont reliés en parallèle à des entrées de commande permettant ainsi, de commander l'acquisition d'une image par mémorisation simultanée desdites informations binaires, de réaliser des traitements simultanés et en parallèle de ces informations binaires, ainsi que d'écrire les résultats des traitements dans des moyens de mémorisation.

Les processeurs utilisés dans le cadre de cette rétine sont connus et constitués par des portes logiques classiques choisies en fonction du traitement à effectuer.

Les inconvénients de cette rétine sont liés au nombre important de commandes nécessaires à son fonctionnement. En effet, douze commandes sont nécessaires, ce qui signifie qu'au moins douze rails de métal déposés sur le substrat doivent traverser chaque cellule, ce qui diminue notablement la densité de points d'image intégrables ainsi que la fiabilité de la rétine.

Le brevet FR2683348 décrit une rétine permettant de remédier à ces inconvénients.

Il décrit un réseau bidimensionnel périodique de mémorisation et de traitement booléen d'images composées de pixels binaires, dont la maille périodique constitue un processeur booléen associé à au moins un pixel. Ce processeur comporte lui-même au moins un registre à décalage unidirectionnel comprenant au moins trois points mémoires.

Un tel processeur permet de recopier une information binaire d'un point mémoire appelé source vers un point mémoire appelé destination, seul ce dernier étant alors modifié.

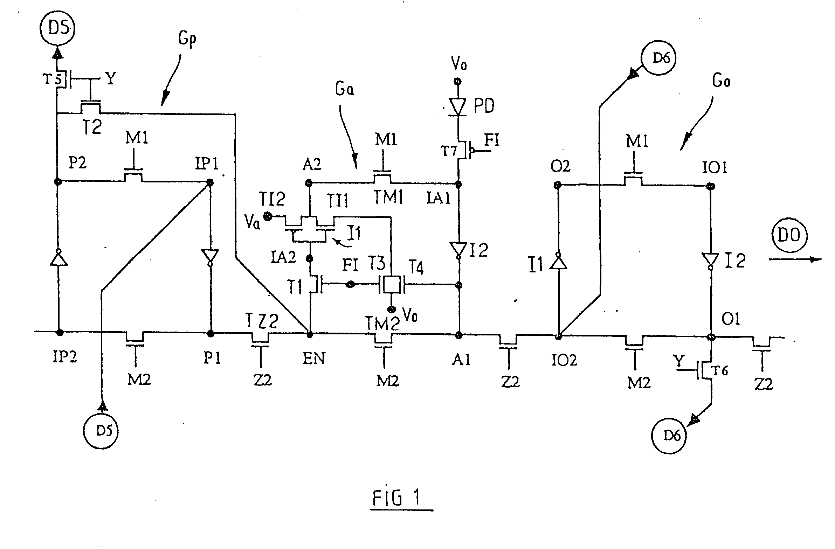

Comme montré sur la figure 1, chaque point mémoire comporte deux inverseurs I2, Il composés chacun de deux transistors TI1 et TI2. L'entrée de I1 est connecté à la sortie de I2 au travers de moyens de commutation TM2, tandis que la sortie est connectée à l'entrée de 12 au travers d'un moyen de commutation TM1. En outre la sortie des inverseurs 12 des points mémoires respectifs Gp et Ga sont connectés aux points mémoire respectifs Ga et Go au travers de moyens de commutation TZ2.

Afin de faciliter la compréhension, les noeuds de connexion, en amont et en aval des inverseurs I2, I1 des points mémoires Gp, Ga et Go, ont été nommés respectivement (IP1, P1, IP2, P2), (IA1, A1, IA2, A2), (IO1, O1, IO2, 02).

Afin d'obtenir une fonction conjonctive, trois transistors, T1, T3 et T4, sont rajoutés au point mémoire destination Ga. Ainsi le transistor T1, qui peut être commandé par un signal FI, est connecté à l'entrée de l'inverseur I1 et aux moyens de commutation commandés TM2 et TZ2, ce dernier point de jonction étant appelé EN. Les transistors T3 et T4 sont connectés en parallèle entre la source du transistor TI1 et la masse Vo. La grille de T3 est reliée à la grille de T1 tandis que celle de T4 est relié au noeud A1. Ainsi, la paire de transistor T3, T4, associée au transistor T1, permet de créer une fonction logique ET et de l'inhiber à volonté comme expliqué ci-après.

Les commandes, appelées aussi horloges dans la suite, des moyens de commutation commandés TM1, TM2, TZ1, T1 sont appélées respectivement M1, M2, Z2, FI. Ces moyens de commutation sont passant uniquement lorsque leur horloge est active.

Par convention, les valeurs P, A et O, des points mémoires respectifs Gp, Ga et Go , sont, respectivement, le niveau logique présent au noeud P1, A1 et 01 et le calcul de la conjonction s'effectue en réalisant aux instants successifs t1, t2, t3, t4, t5 les séquences de commande suivantes :

> à l'instant t1 : M1 M2 FI
> à l'instant t2 : FI Z2
> à l'instant t3 : M2
> à l'instant t4 : M1 M2
> à l'instant t5 : M1 M2 FI

L'écriture précédente des séquences de commande signifie que :

* les horloges M1, M2 et FI sont activées à l'instant t1;
* les horloges M1 et M2 sont desactivées, puis Z2 est activée à l'instant t2;
* FI et Z2 sont desactivées puis M2 est activée à l'instant t3;

* M1 est activée à l'instant t4
* FI est activée à l'instant t5.

Il est à noter que la désactivation des horloges doit systématiquement précéder l'activation d'autres horloges lors du passage d'un temps au suivant. Ce principe de séquencement est dénommé horloges multiphases.

Les états aux instants t1 et t5 correspondent à l'état stable, ou statique, des points mémoires Gp, Ga , et Go, dans lequel les inverseurs sont rebouclés en une structure de mémoire statique.

L'étape t2 provoque la copie au noeud IA2 de la valeur de P. Pendant cette étape, la valeur de P est stockée de façon dynamique à l'entrée de l'inverseur IP1-P1 grâce à la capacité d'entrée naturelle de celui-ci.

L'étape t3 sert à rétablir l'intégrité des valeurs en d'autres points (non tous représentés) du processeur.

L'étape t4 reboucle les points mémoire, et stocke donc dans le point Ga le résultat du calcul. Celui-ci est la valeur P de Gp si A valait 1, l'inverseur modifié ayant pour entrée IA2 étant alors pleinement opérationnel. Dans le cas où A valait 0, alors le noeud A2, initialement au niveau 1, ne peut être déchargé quelle que soit la valeur de IA2, et A reste donc à 0.

Finalement, au temps t5, la valeur initiale A du point mémoire Ga a été remplacée par la valeur A et P tandis que les valeurs des points mémoires Gp et Go sont restées identiques et égales respectivement à P et à O.

Par convention, on note :

$$P, A, O \rightarrow P, A \text{ ET } P, O$$

P, A, O étant l'état initial des points mémoire respectifs Gp, Ga et Go et P, A ET P, O l'état final au temps t5.

Enfin on peut noter que l'utilisation d'un moyen de commutation commandable supplémentaire, en l'occurrence le transistor T2, connecté entre la sortie de l'inverseur I1 du point mémoire Gp et le point de jonction EN permettrait d'obtenir la valeur A et non P au point mémoire Ga à l'instant t5. Pour cela, il suffirait de remplacer, à l'instant t2, la commande Z2 par la commande, appelée Y, du transistor T2.

Un tel processeur présente l'inconvénient de nécessiter trois transistors supplémentaires par rapport à un simple point mémoire. De plus, l'utilisation de seulement deux points mémoire ne permet que le calcul du ET logique, avec ou sans complémentation, ainsi que la copie avec complémentation. Le calcul du OU exclusif des deux points mémoire A et P exige l'utilisation d'un troisième point mémoire de stockage temporaire, ainsi qu'une longue séquence d'horloges pour effectuer le calcul.

Le but de l'invention est de remédier à ces inconvénients en proposant un dispositif de traitement d'information, ainsi qu'un procédé, plus simple aussi bien dans le nombre de composants mis en oeuvre que dans les séquences nécessaires à l'obtention des fonctions logiques ET et OU, et permettant, en outre, l'obtention de fonctions logiques plus complexes comme XOR et XNOR.

La solution proposée est d'une part un procédé de traitement de deux informations binaires A et B en vue de l'obtention d'une conjonction ou d'une disjonction de ces valeurs et/ou de leur complémentaire, les deux informations binaires A et B étant stockées respectivement dans un premier et un second points mémoire semi-statique appartenant ou non à un même registre à décalage, chacun de ces points mémoire comportant un premier et un deuxième inverseurs installés dans le même sens de rotation, la sortie du premier inverseur étant connectée à l'entrée du second à travers des premiers moyens de commutation commandés et la sortie du deuxième inverseur étant connectée à l'entrée du premier à travers des seconds moyens de commutation commandés, la tension en sortie du deuxième inverseur étant représentative de l'information binaire du point, procédé caractérisé en ce qu'il comporte une étape de mélange de la charge de deux capacités, l'une de ces charges étant représentative de l'information binaire A ou de son complémentaire et l'autre représentative de l'information binaire B ou de son complémentaire ainsi qu'au moins un seuillage de la tension résultant du mélange des deux charges.

Selon une caractéristique additionnelle, le mélange des charges est réalisé par connexion de l'entrée du second inverseur du second point mémoire et d'autre part avec l'entrée du premier inverseur du premier point mémoire, la connexion pouvant par exemple être réalisée par commande de la fermeture de troisième moyens de commutation commandés. On utilise ainsi la capacité naturelle intrinsèque de l'entrée des inverseurs pour faire le mélange des charges.

Selon une caractéristique, le seuillage de la tension résultant du mélange de charge comporte les étapes suivantes :

- alimenter en basse tension au moins un inverseur,
- imposer un état logique à la sortie de cet inverseur
- appliquer la tension résultant du mélange des charges à l'entrée de cette inverseur.

Selon une autre caractéristique, le seuillage de la tension résultant du mélange des charges est réalisé par un inverseur comportant un seuil bas Vsb compris entre une tension minimale équivalente à un ZERO logique et la demi somme de la tension minimale et d'une tension maximale correspondante à un UN logique, de telle sorte que pour toute tension V en entrée de cette inverseur, la tension en sortie est égale à ladite tension maximale si la tension à l'entrée est inférieure à Vsb tandis qu'elle est égale à la tension minimale si cette tension V est supérieure à Vsb, et/ou par un inverseur comportant un seuil haut Vsh compris entre la demi somme de de la tension minimale et de la tension maximale, et cette dernière tension, de telle sorte que pour toute tension V en entrée de cette inverseur, la tension en sortie est égale à la tension maximale si la tension à l'entrée est inférieure à Vsh tandis qu'elle est égale à la tension minimale si cette tension V est supérieure à Vsh.

Selon une caractéristique supplémentaire, le procédé comporte au moins deux seuillages de la charge résultant du mélange, ces seuillages étant réalisés par les inverseurs I2 et/ou I1 connectés aux troisième moyens de commutation commandés.

La solution proposée est d'autre part un dispositif de traitement de deux informations binaires A et B en vue de l'obtention d'une conjonction ou d'une disjonction de ces valeurs et/ou de leur complémentaire, les deux informations binaires A et B étant stockées respectivement dans un premier et un second points mémoire semi-statique appartenant ou non à un même registre à décalage, chacun de ces points mémoire comportant un premier et un deuxième inverseurs installés dans le même sens de rotation, la sortie du premier inverseur étant connectée à l'entrée du second à travers des premiers moyens de commutation commandés et la sortie du deuxième inverseur étant connectée à l'entrée du premier à travers des seconds moyens de commutation commandés, la tension en sortie du deuxième inverseur étant représentative de l'information binaire du point, caractérisé en ce qu'il comporte des troisième moyens de commutation commandés aptes à connectés l'entrée de l'un des premier et second inverseurs du premier mémoire à l'entrée de l'un des inverseurs du second point mémoire, et des moyens de seuillage connectés à l'une au moins des dites entrées des inverseurs.

Selon une caractéristique additionnelle permettant de limiter le nombre de composants électroniques nécessaires, les moyens de seuillage sont constitués par l'un au moins des inverseurs connectés entre eux par les troisième moyens de commutation commandés.

Selon une caractéristique particulière, ledit au moins un inverseur comportant un seuil bas Vsb compris entre une tension minimale équivalente à un ZERO logique et la demi somme de la tension minimale et d'une tension maximale correspondante à un UN logique, de telle sorte que pour toute tension V en entrée de cette inverseur, la tension en sortie est égale à ladite tension maximale si la tension à l'entrée est inférieure à Vsb tandis qu'elle est égale à la tension minimale si cette tension V est supérieure à Vsb, et/ou par un inverseur comportant un seuil haut Vsh compris entre la demi somme de de la tension minimale et de la tension maximale, et cette dernière tension, de telle sorte que pour toute tension V en entrée de cette inverseur, la tension en sortie est égale à la tension maximale si la tension à l'entrée est inférieure à Vsh tandis qu'elle est égale à la tension miniùmale si cette tension V est supérieure à Vsh.

Selon une caractéristique supplémentaire, le procédé comporte au moins deux seuillages de la tension résultant du mélange de charges, ces seuillages étant réalisés par les inverseurs I2 et/ou I1 connectés aux troisième moyens de commutation commandés.

La solution proposée est d'autre part un dispositif de traitement de deux informations binaires A et B en vue de l'obtention d'une conjonction ou d'une disjonction de ces valeurs et/ou de leur complémentaire, les deux informations binaires A et B étant stockées respectivement dans un premier et un second points mémoire semi-statique appartenant ou non à un même registre à décalage, chacun de ces points mémoire comportant un premier et un deuxième inverseurs installés dans le même sens de rotation, la sortie du premier inverseur étant connectée à l'entrée du second à travers des premiers moyens de commutation commandés et la sortie du deuxième inverseur étant connectée à l'entrée du premier à travers des seconds moyens de commutation commandés, la tension en sortie du deuxième inverseur étant représentative de l'information binaire du point, caractérisé en ce qu'il comporte des troisième moyens de commutation commandés aptes à connecter l'entrée de l'un des premier et second inverseurs du premier mémoire à l'entrée de l'un des inverseurs du second point mémoire, et des moyens de seuillage connectés à l'une au moins des dites entrées des inverseurs.

Selon une caractéristique additionnelle permettant de limiter le nombre de composants électroniques nécessaires, les moyens de seuillage sont constitués par l'un au moins des inverseurs connectés entre eux par les troisième moyens de commutation commandés.

Selon une caractéristique particulière, ledit au moins un inverseur comporte soit un seuil bas Vsb compris entre une tension minimale équivalente à un ZERO logique et la demi somme de la tension minimale et d'une tension maximale correspondante à un UN logique, de telle sorte que pour toute tension V en entrée de cette inverseur, la tension en sortie est égale à ladite tension maximale si la tension à l'entrée est inférieure à Vsb tandis qu'elle est égale à la tension minimale si cette tension V est supérieure à Vsb, soit un seuil haut Vsh compris entre la demi somme de de la tension minimale et de la tension maximale, et cette dernière tension, de telle sorte que pour toute tension V en entrée de cette inverseur, la tension en sortie est égale à la tension maximale si la tension à l'entrée est inférieure à Vsh tandis qu'elle est égale à la tension miniùmale si cette tension V est supérieure à Vsh.

Selon une caractéristique permettant d'obtenir simplement toutes les fonctions logiques relatives aux informations binaire A et B et à leurs complémentaires, le dispositif comporte en outre des troisième moyens d'inversion et des quatrième moyens de commutation commandés connectés les uns aux autres en série et connectés entre la sortie de l'un des inverseurs et l'entrée de l'autre inverseur du même point mémoire, en parallèle avec les moyens de commutation commandés reliant ces mêmes inverseurs.

Selon une autre caractéristique, il comporte en outre des cinquième moyens de commutation commandés connectés entre l'entrée de l'un des inverseurs d'un des points mémoire et l'entrée de l'un des inverseurs de l'autre point mémoire, l'un au moins desdits inverseurs connectés auxdits cinquième moyens de commutation étant un inverseur non connecté aux troisièmes moyens de commutation commandés.

Les moyens de commutation commandés TM1, TM2, Tc, Ts et Tx peuvent par exemple être constitués par des transistors.

Afin de permettre notamment le stockage de résultats de calculs intermédiaires, le dispositif comporte un ou plusieurs autres points mémoire associés aux premier et second points mémoire.

L'invention a aussi pour objet une rétine artificielle comportant un réseau bidimensionnel périodique de mémorisation et de traitement booléen d'images composées de pixels binaires, dont la maille périodique constitue un processeur booléen associé à au moins un pixel, caractérisée en ce qu'au moins un de ces processeurs booléens est constitué par un dispositif selon l'invention.

D'autres avantages et caractéristiques apparaîtront dans la description de modes particuliers de réalisation de l'invention au regard des figures annexées parmi lesquelles :

- la figure 1 montre un exemple de processeur selon l'état de la technique,
- la figure 2 présente un premier exemple de réalisation de l'invention,
- la figure 3 présente un second exemple de réalisation de l'invention,
- la figure 4 présente un troisième exemple de réalisation de l'invention,
- la figure 5 présente un troisième exemple de réalisation de l'invention.

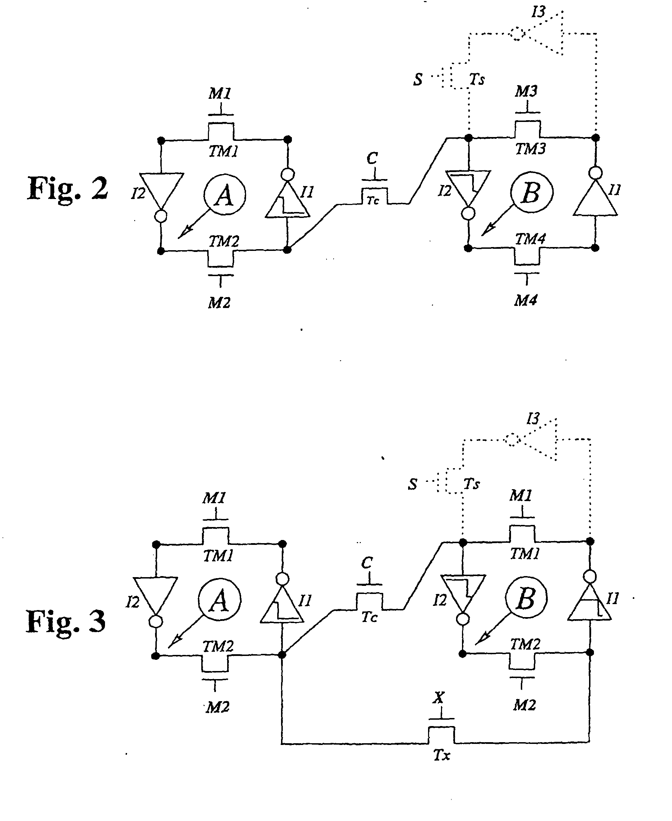

Les moyens de l'invention présentés sur la figure 2 comportent d'une part deux points mémoire semi-statique Ga et Gb appartenant à deux registres à décalage différents. Le point mémoire Ga comporte deux inverseurs I1 et I2 installés dans le même sens de rotation, la sortie de I1 étant connectée à l'entrée de I2 à travers un interrupteur TM1 et la sortie de I2 étant connectée à l'entrée de I1 à travers un interrupteur TM2, la tension en sortie de I2 étant représentative de l'information binaire de ce point.

Le point mémoire Gb comporte deux inverseurs I1 et I2 installés dans le même sens de rotation, la sortie de I1 étant connectée à l'entrée de I2 à travers un interrupteur TM3 et la sortie de I2 étant connectée à l'entrée de I1 à travers un interrupteur TM4, la tension en sortie de I2 étant représentative de l'information binaire de ce point.

Cette tension prend habituellement deux valeurs à savoir Vmin ou Vmax , la valeur du point correspondante étant interprétée comme un ZERO ou un UN logique. En l'occurrence les tensions utilisées dans cet exemple de réalisation sont respectivement 0V et la tension d'alimentation du circuit, à savoir 5V dans cet exemple de réalisation.

Les moyens de l'invention comportent d'autre part une connexion, à travers des moyens de commutation commandés Tc, entre l'entrée de l'inverseur I1 du point mémoire Ga et l'entrée de l'inverseur I2 du point mémoire Gb.

En outre, l'inverseur I1 du point mémoire Ga comporte un seuil bas Vsb compris entre Vmin et la demi somme de Vmin et Vmax, de telle sorte que pour toute tension V en entrée de cet inverseur, la tension en sortie est égale à Vmax si la tension à l'entrée est inférieure à Vsb tandis qu'elle est égale à Vmin si cette tension V est supérieure à Vsb.

De plus, l'inverseur I2 du point mémoire Gb comporte un seuil haut Vsh compris entre la demi somme de Vmin et Vmax et Vmax, c'est à dire que pour toute tension V en entrée de cet inverseur, la tension en sortie est égale à Vmax si la tension à l'entrée est inférieure à Vsh tandis qu'elle est égale à Vmin si cette tension V est supérieure à Vsh.

Lorsque les moyens de commutation commandés Tc sont rendus passant, les charges initialement présentes à l'entrée des deux inverseurs se mélangent. A la charge résultant correspond une tension Vmin équivalente à un ZERO logique (respectivement une tension Vmax correspondant à un UN logique) lorsque les valeurs initiales étaient égales toutes deux à Vmin (respectivement Vmax). Lorsque les valeurs de départ sont différentes, l'une étant égale à Vmin et l'autre à Vmax, le mélange des charges conduit à une valeur de tension intermédiaire approximativement égale à la demi somme de Vmin et Vmax.

L'application de cette tension à l'entrée d'un inverseur dont le seuil a été volontairement décalé vers le haut ou vers le bas par rapport à cette tension intermédiaire conduit ainsi à calculer la conjonction (ET logique) ou respectivement la disjonction (OU logique) des valeurs booléennes correspondant aux charges de départ.

L'utilisation simultanée de deux inverseurs ayant un seuil bas pour l'un et haut pour l'autre permet de calculer la conjonction dans l'un des points mémoire et la disjonction dans l'autre en un seul mélange de charges.

Ainsi en réalisant aux instants successifs t1, t2, t3, t4 les séquences de commande suivantes :

à l'instant t1 : M1 M2 M3 M4
à l'instant t2 : C
à l'instant t3 : M1 M4

à l'instant t4 M1 M2 M3 M4

on obtient, à partir des valeurs initiales A et B, la valeur A ou NonB pour le point mémoire Ga et NonA ou B pour le point mémoire Gb.

D'autres fonction logiques peuvent être simplement obtenues avec ce processeur.

A titre d'exemple, si, à t3, M2 avait été réactivée à la place de M1, le point A aurait conservé la donnée A. De la même manière, si M3 avait été réactivée à la place de M4, le point B aurait conservé la donnée B. On constate qu'en disposant des moyens d'inversions, en place de la donnée présente dans chaque point mémoire, en l'occurrence par ajout d'un inverseur 13 et des moyens de commutation commandés Ts, il est possible d'obtenir les huit fonctions booléennes du type ET et OU sur les deux variables A et B ou leurs complémentaires. En outre, utilisant la séquence d'horloges détaillée ci-dessus, une fois que les deux points mémoire sont respectivement occupés par (A ou NonB) et (NonA ou B), il suffit d'inverser l'un des deux puis de faire de nouveau interagir les deux points mémoire de la même manière pour obtenir le XOR (puis le XNOR après une nouvelle inversion).

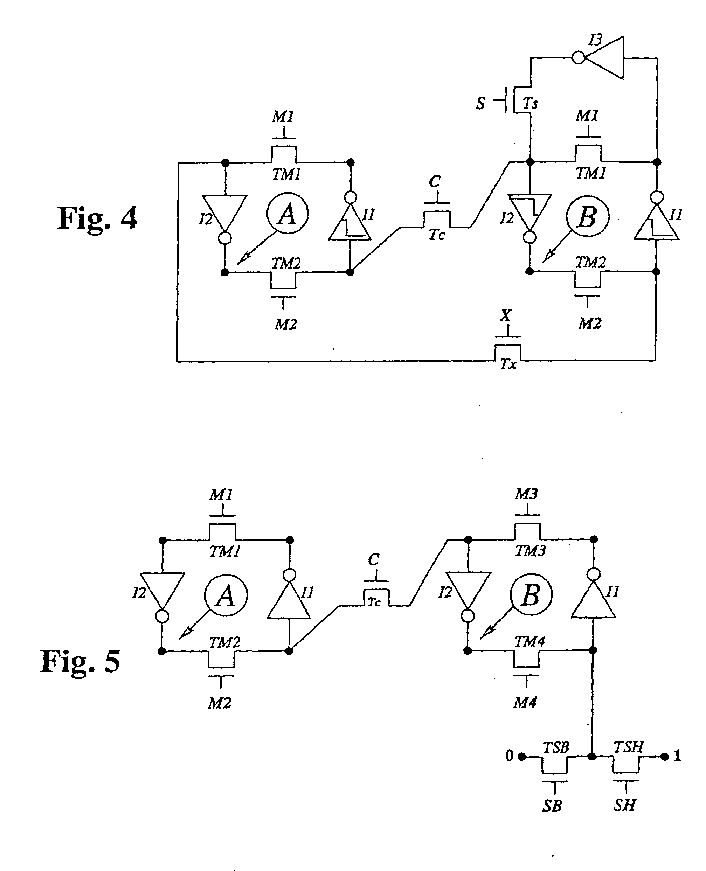

Les figures 3 et 4 présentent des structures plus spécifiques, dans lesquelles les moyens d'inversion et de commutation 13, sont remplacés totalement ou partiellement par des solutions présentant une double connexion entre entrées d'inverseur appartenant à deux points mémoire distincts. Il existe deux configurations possibles. Soit ils sont connectés deux à deux comme sur la figure 4, soit l'entrée d'un inverseur d'un point mémoire est connectée à chacune des entrées des deux inverseurs de l'autre comme sur la figure 3. De plus, ce sont les mêmes horloges M1 et M2 qui sont utilisées pour la mémorisation dans les deux points mémoire par souci de minimisation du nombre de commandes nécessaires. Ces deux structures permettent le calcul du XOR ou du XNOR ainsi que d'autres fonctions booléennes comme cela est explicité ci-dessous.

L'utilisation des horloges X et C sur la figure 3 permet par le procédé déjà exposé d'obtenir le calcul du XNOR (OU-exclusif complémenté) par la séquence

à l'instant t1- M1 M2
à l'instant t2- X
à l'instant : t3- M1
à l'instant: t4- M1 M2
à l'instant t5- C
à l'instant : t6- M2
à l'instant t7- M1 M2

Cette séquence conduit à :

A, B → A ou B, A XNOR B.

Afin de rendre possible l'inversion du OU-exlusif complémenté, et pour permettre la réalisation de nombreuses autres fonctions de calcul et de recopie entre les points mémoire binaires A et B, il peut être souhaitable d'ajouter à cette structure un dispositif d'inversion représenté en pointillés sur la figure 3.

Sur la figure 4, la présence des moyens d'inversion et de commutation I3 et Ts est ici indispensable au fonctionnement. Cette structure ne nécessite que trois transistors supplémentaires, par rapport à une structure de réseau à décalage semi-statique seule, si ces moyens sont associés à un troisième point mémoire.

Dans cette dernière disposition, le calcul d'un OU-exclusif s'obtient par la séquence :

à l'instant : t1- M1 M2
à l'instant. t2- X C
à l'instant t3- M1
à l'instant t4- M1 M2
à l'instant : t5- S
à l'instant : t6- C
à l'instant : t7- M2
à l'instant : t8- M1 M2

qui conduit, à l'étape t4 à A,B -> A ou NonB, NonA ou B. La séquence complète calcule en définitive A, B -> A ou NonB, A xor B.

Il est à noter que les dispositions présentées sur les figures 3 et 4 continuent à fournir les fonctions logiques XOR ou XNOR si les inverseurs à seuil bas sont remplacés par des inverseurs à seuil haut et réciproquement.

Par ailleurs, les caractéristiques des inverseurs fonctionnant à faible tension sont telles que la tension résultant du mélange des charges peut être seuillée avec un inverseur ordinaire, c'est-à-dire dont le seuil de fonctionnement est quelconque.

En effet, un inverseur élémentaire (formé d'une paire NMOS-PMOS) utilisé avec une tension d'alimentation Vmax très basse (environ la somme de la tension de seuil d'un transistor NMOS et d'un transistor PMOS, ou moins), se trouve dans une situation pour laquelle aucun de ses deux transistors ne conduit beaucoup lorsque la tension d'entrée est voisine de la demi-somme de Vmax et Vmin. Son impédance de sortie est ainsi très faible si l'entrée est à un niveau logique 0 ou 1, et élevée lorsque l'entrée est à une tension issue du mélange des charges contenues dans deux capacités de valeur similaire, l'une étant initialement au niveau 1 et l'autre au niveau 0.

Dans le cas où la capacité pilotée par la sortie de l'inverseur est suffisamment importante et les horloges suffisamment rapides, le niveau présent sur la sortie de cet inverseur n'est que peu modifié si l'entrée évolue vers cet état intermédiaire.

L'utilisation judicieuse de cette technique permet d'émuler ainsi avec un inverseur simple le comportement d'un inverseur à seuil haut ou d'un inverseur à seuil bas, selon la valeur binaire stockée précédemment sur sa sortie. Ce principe permet le fonctionnement des circuits des figures 2 à 4 avec des inverseurs tous identiques, à condition cependant d'ajouter aux séquences d'horloges les bonnes initialisations qui contrôlent le fonctionnement en porte ET ou en porte OU avant chaque calcul.

La figure 5 montre un dispositif selon l'invention dans lequel les inverseurs sont alimentés en basse tension. L'inverseur I2 du point mémoire Gb, qui est identique aux autres inverseurs, fonctionne comme un inverseur à seuil bas ou à seuil haut. Pour cela l'entrée de l'inverseur I1 du point mémoire Gb reliée à la sortie de l'inverseur I2 à travers le transistor TM4, est de surcroît connectée à deux moyens de commutations TSB et TSH, le premier étant lui même connecté à la tension Vmin tandis que le second est relié à la tension Vmax.

L'utilisation de ce dispositif permet de calculer la conjonction ou la disjonction lorsque, respectivement l'horloge SB ou SH est activée

En effet, en imposant un état logique 1 en entrée de l'inverseur I1 par activation des moyens de commutation TSH, cet état logique est conservé lors de l'activation de M4 si la tension à l'entrée de cet inverseur, résultant du mélange des charges, est égale à Vmin ou à une valeur intermédiaire entre Vmin et Vmax. Par contre cet état logique passe à 0 si la tension d'entrée est égale à Vmax.

Ainsi en réalisant aux instants successifs t1, t2, t3, t4 les séquences de commande suivantes :

à l'instant t1 : M1 M2 M3 M4
à l'instant t2 : C SH
à l'instant t3 : M1 M4
à l'instant t4 : M1 M2 M3 M4

on obtient, à partir des valeurs initiales A et B, la valeur A pour le point mémoire Ga et NonA OU B pour le point mémoire Gb.

Si l'horloge SB avait été activée à la place de l'horloge SH, on aurait obtenu , à partir des mêmes valeurs initiales, la valeur A pour le point mémoire Ga et NonA ET B pour le point mémoire Gb.

Un processeur selon l'invention peut être utilisé dans de nombreuses applications dont celle des capteurs de vision programmables intégrant le traitement d'images dans le plan focal. A ce titre on peut citer la réalisation de rétines artificielles telles que celles décrites dans les brevets FR2583602 et FR2683348 et comportant un réseau bidimensionnel périodique de mémorisation et de traitement booléen d'images composées de pixels binaires, dont la maille périodique constitue un processeur booléen associé à au moins un pixel. A ce pixel, sont associés une photodiodes et des moyens de commutation commandés ainsi qu'un processeur selon l'invention.

Il est évident que de nombreuses modifications peuvent être apportées au mode de réalisation présenté. Ainsi,dans le cadre de la figure 4, avec quelques légères modifications, et si l'on tolère des séquences de calcul plus longues, il est possible de supprimer l'horloge X tout en conservant l'aptitude au calcul du XOR. Ceci peut présenter l'avantage de limiter au strict minimum le nombre de capacités d'entrée d'inverseurs à apparier.

De plus, les inverseurs I1, I2 connectés au moyens de commutation commandés Tc pourraient être ceux d'un même point mémoire, par exemple Ga, au lieu d'appartenir à deux points mémoire différents comme présenté sur la figure 2.

Par ailleurs, les exemples de structures présentés comme illustration des idées inventives sont en technologie CMOS. Néanmoins, les principes restent transposables sur d'autres technologies comme le BiCMOS.

## Revendications

1. Procédé de traitement de deux informations binaires A et B en vue de l'obtention d'une conjonction ou d'une disjonction de ces valeurs et/ou de leur complémentaire, les deux informations binaires A et B étant stockées respectivement dans des points mémoire semi-statique (Ga) et (Gb) appartenant ou non à un même registre à décalage, chacun de ces points mémoire comportant deux inverseurs I1 et I2 installés dans le même sens de rotation, la sortie de l'inverseur I1 étant connectée à l'entrée de l'inverseur I2 à travers des moyens de commutation commandés (TM1,TM2) et la sortie de l'inverseur I2 étant connectée à l'entrée de I1 à travers des moyens de commutation commandés (TM2,TM4), la tension en sortie de de l'inverseur I2 étant représentative de l'information binaire du point, procédé **caractérisé en ce qu'**il comporte une étape de mélange de la charges de deux capacités, l'une des charges étant représentative de l'information binaire A ou de son complémentaire et l'autre représentative de l'information binaire B ou de son complémentaire ainsi qu'au moins un seuillage de la tension résultant du mélange des deux charges.

2. Procédé selon la revendication 1, **caractérisé en ce que** le mélange des charges est réalisé par connexion de l'entrée de l'inverseur I2 du point mémoire Ga et d'autre part avec l'entrée de l'inverseur I1 du point mémoire Gb.

3. Procédé selon la revendication 2; **caractérisé** en ce la connexion est réalisée par commande de la fermeture de moyens de commutations commandés Tc.

4. Procédé selon l'une quelconque des revendications 1 à 3, **caractérisé en ce que** le seuillage de la tension résultant du mélange des charges comporte les étapes suivantes :

- alimenter en basse tension au moins un inverseur (I1,I2),
- appliquer la tension résultant du mélange des charges à l'entrée de cette inverseur.
- imposer l'interprétation de la sortie de cet inverseur lorsque la tension résultant du mélange de charge est comprise entre Vmin et Vmax.

5. Procédé selon l'une quelconque des revendications 1 à 3, **caractérisé en ce que** le seuillage de la tension résultant du mélange des charges est réalisé par un inverseur comportant un seuil bas Vsb compris entre une tension minimale équivalente à un ZERO logique et la demi-somme de la tension minimale et d'une tension maximale correspondante à un UN logique, de telle sorte que pour toute tension V en entrée de cet inverseur, la tension en sortie est égale à ladite tension maximale si la tension à l'entrée est inférieure à Vsb tandis qu'elle est égale à la tension minimale si cette tension V est supérieure à Vsb, soit par un inverseur comportant un seuil haut Vsh compris entre la demi somme de de la tension minimale et de la tension maximale, et cette dernière tension, de telle sorte que pour toute tension V en entrée de cette inverseur, la tension en sortie est égale à la tension maximale si la tension à l'entrée est inférieure à Vsh tandis qu'elle est égale à la tension minimale si cette tension V est supérieure à Vsh.

6. Procédé selon la revendication 5, **caractérisé en ce qu'**il comporte au moins deux seuillages de la tension résultant du mélange des charges et **en ce que** ces seuillages sont réalisés par les inverseurs I2 et/ou I1 connectés aux moyens de commutation commandé Tc.

7. Dispositif de traitement de deux informations binaires A et B en vue de l'obtention d'une conjonction ou d'une disjonction de ces valeurs et/ou de leur complémentaire, les deux informations binaires B et A étant stockées respectivement dans des points mémoire semi statique Ga et Gb appartenant ou non à un même registre à décalage, chacun de ces points mémoire comportant deux inverseurs I1,I2 installés dans le même sens de rotation, la sortie de l'inverseur I1 étant connectée à l'entrée de l'inverseur I2 à travers des moyens de commutation (TM1,TM3) et la sortie de de l'inverseur I2 étant connectée à l'entrée de l'inverseur I1 à travers des moyens de commutation (TM2,TM4) la tension en sortie de l'inverseur I2 étant représentative de l'information binaire du point, **caractérisé en ce qu'**il comporte des moyens (Tc) de commutation commandés aptes à connectés l'entrée de l'un des inverseurs (I1, I2) du point mémoire Ga à l'entrée de l'un des inverseurs (I1, I2) du point mémoire Gb, et des moyens de seuillage connectés à l'une au moins des dites entrées des inverseurs.

8. Dispositif selon la revendication 7, **caractérisé en ce que** les moyens de seuillage sont constitués par l'un au moins des inverseurs (I1, I2) connectés entre eux par des moyens (Tc) de commutation commandés.

9. Dispositif selon la revendication 8, **caractérisé en ce que** ledit au moins un inverseur comporte soit un seuil bas Vsb compris entre Tmin et la demi somme de Tmin et Tmax, de telle sorte que pour toute tension V en entrée de cette inverseur, la tension en sortie est égale à Tmax si la tension à l'entrée est inférieure à Vsb tandis qu'elle est égale à Tmin si cette tension V est supérieure à Vsb, soit un seuil haut Vsh compris entre la demi somme de Tmin et Tmax et Tmax, c'est à dire que pour toute tension V en entrée de cette inverseur, la tension en sortie est égale à Tmax si la tension à l'entrée est inférieure à Vsh tandis qu'elle est égale à Tmin si cette tension V est supérieure à Vsh.

10. Dispositif selon l'une quelconque des revendications 7 à 9, **caractérisé en ce qu'**il comporte en outre des moyens d'inversion I3 et des moyens (Ts) de commutation commandés connectés les uns aux autres en série et connectés entre la sortie de l'un des inverseurs (I1,I2) et l'entrée de l'autre inverseur du même point mémoire Ga et/ou Gb, en parallèle avec les moyens (TM3) de commutation commandés reliant ces mêmes inverseurs.

11. Dispositif selon l'une quelconque des revendications 7 à 10, **caractérisé en ce qu'**il comporte en outre des moyens (Tx) de commutation commandés connectés entre l'entrée de l'un des inverseurs (I1,I2) d'un des points mémoire (Ga, Gb) et l'entrée de l'un des inverseurs (I1,I2) de l'autre des points mémoire, l'un au moins des dits inverseurs connectés aux moyens (Tx) étant un inverseur non connecté aux moyens de commutation commandés (Tc).

12. Dispositif selon l'une quelconque des revendications 7 à 11, **caractérisé en ce qu'**il comporte au moins un troisième point mémoire (Go) associé aux points mémoire Ga et Gb.

13. Rétine artificielle comportant un réseau bidimensionnel périodique de mémorisation et de traitement booléen d'images composées de pixels binaires, dont la maille périodique constitue un processeur booléen associé à au moins un pixel, **caractérisée en ce qu'**au moins un de ces processeurs booléens est constitué par un dispositif selon l'une quelconque des revendications 7 à 12.

## Claims

1. Method of processing two items of binary information A and B with the intention of obtaining a conjunction or disjunction of these values and/or of their complement, the two items of binary information A and B being stored respectively in the semi-static memory points (Ga) and (Gb) belonging or not to the same shift register, each of these memory points including two inverters I1 and I2 which are installed in the same rotary direction, the output of the inverter I1 being connected to the input of the inverter I2 across controlled switching means (TM1, TM2) and the output of the inverter I2 being connected to the input of I1 across controlled switching means (TM2, TM4), the output voltage of the inverter I2 representing the binary information of the point, the method being **characterized in that** it includes a stage of mixing the charge of two capacitors, one of the charges representing the item of binary information A or its complement and the other representing the item of binary information B or its complement, and at least one thresholding of the voltage resulting from the mixture of the two charges.

2. Method according to Claim 1, **characterized in that** the charges are mixed by connecting the input of the inverter I2 of the memory point Ga to the input of the inverter I1 of the memory point Gb.

3. Method according to Claim 2, **characterized in that** the connection is implemented by control of the closing of controlled switching means Tc.

4. Method according to one of Claims 1 to 3, **characterized in that** the thresholding of the voltage resulting from the mixture of charges includes the following stages:

   - supplying at least one inverter (I1, I2) with low voltage,

   - applying the voltage resulting from the mixture of charges to the input of this inverter,

   - imposing the interpretation of the output of this inverter when the voltage which results from the mixture of the charge is between Vmin and Vmax.

5. Method according to one of Claims 1 to 3, **characterized in that** the thresholding of the voltage resulting from the mixture of charges is implemented by an inverter including a low threshold Vsb between a minimum voltage which is equivalent to a logical ZERO and the half-sum of the minimum voltage and a maximum voltage corresponding to a logical ONE, in such a way that for any voltage V at the input to this inverter, the output voltage equals the said maximum voltage if the input voltage is less than Vsb, whereas it equals the minimum voltage if this voltage V is greater than Vsb, or by an inverter including a high threshold Vsh between the half-sum of the minimum voltage and the maximum voltage and the latter voltage, in such a way that for any voltage V at the input to this inverter, the output voltage equals the maximum voltage if the input voltage is less than Vsh, whereas it equals the minimum voltage if this voltage V is greater than Vsh.

6. Method according to Claim 5, **characterized in that** it includes at least two thresholdings of the voltage resulting from the mixture of charges, and that these thresholdings are implemented by inverters I1 and/or I2 which are connected to the controlled switching means Tc.

7. Device for processing two items of binary information A and B with the intention of obtaining a conjunction or disjunction of these values and/or of their complement, the two items of binary information B and A being stored respectively in the semi-static memory points Ga and Gb belonging or not to the same shift register, each of these memory points including two inverters I1, I2 which are installed in the same rotary direction, the output of the inverter I1 being connected to the input of the inverter I2 across controlled switching means (TM1, TM3) and the output of the inverter I2 being connected to the input of the inverter I1 across controlled switching means (TM2, TM4), the output voltage of the inverter I2 representing the binary information of the point, **characterized in that** it includes controlled switching means (Tc) which are suitable for connecting the input of one of the inverters (I1, I2) of the memory point Ga to the input of one of the inverters (I1, I2) of the memory point Gb, and means of thresholding which are connected to at least one of the said inverter inputs.

8. Device according to Claim 7, **characterized in that** the thresholding means are constituted by at least one of the inverters (I1, I2) which are connected to each other by controlled switching means (Tc).

9. Device according to Claim 8, **characterized in that** the said at least one inverter includes either a low threshold Vsb between Tmin and the half-sum of Tmin and Tmax, in such a way that for any voltage V at the input to this inverter, the output voltage equals Tmax if the input voltage is less than Vsb, whereas it equals Tmin if this voltage V is greater than Vsb, or a high threshold Vsh between the half-sum of Tmin and Tmax and Tmax, i.e. for any voltage V at the input to this inverter, the output voltage equals Tmax if the input voltage is less than Vsh, whereas it equals Tmin if this voltage V is greater than Vsh.

10. Device according to one of Claims 7 to 9, **characterized in that** it also includes inversion means 13 and controlled switching means (Ts) which are connected to each other in series and connected between the output of one of the inverters (I1, 12) and the input of the other inverter of the same memory point Ga and/or Gb, in parallel with controlled switching means (TM3) connecting these inverters.

11. Device according to one of Claims 7 to 10, **characterized in that** it also includes controlled switching means (Tx) which are connected between the input of one of the inverters (I1, 12) of one of the memory points (Ga, Gb) and the input of one of the inverters (I1, 12) of the other of the memory points, at least one of the said inverters which are connected to the means (Tx) being an inverter which is not connected to the controlled switching means (Tc).

12. Device according to one of Claims 7 to 11, **characterized in that** it includes at least a third memory point (Go) which is associated with the memory points Ga and Gb.

13. Artificial retina including a two-dimensional periodic network for recording and Boolean processing of images consisting of binary pixels, the periodic mesh constituting a Boolean processor which is associated with at least one pixel, **characterized in that** at least one of these Boolean processors is constituted by a device according to one of Claims 7 to 12.

**Patentansprüche**

1. Verfahren zur Verarbeitung von zwei binären Informationen A und B mit dem Ziel, eine Konjunktion oder eine Disjunktion dieser Werte und/oder ihrer komplementären Werte zu erhalten, wobei die zwei binären Informationen A und B in halbstatischen Speicherpunkten (Ga) bzw. (Gb) gespeichert sind, die einem gleichen Schieberegister angehören oder nicht, wobei jeder dieser Speicherpunkte zwei Inverter I1 und I2 enthält, die im gleichen Drehsinn angeordnet sind, wobei der Ausgang des Inverters I1 verbunden ist mit dem Eingang des Inverters I2 über Mittel zur gesteuerten Umschaltung (TM1, TM2) und der Ausgang des Inverters I2 mit dem Eingang I1 verbunden ist über Mittel zur gesteuerten Umschaltung (TM2, TM4), wobei die Ausgangsspannung des Inverters I2 für die binäre Information des Punktes steht, Verfahren **dadurch gekennzeichnet, daß** es einen Schritt zur Mischung der Ladungen zweier Kapazitäten umfaßt, wobei eine der Ladungen für die binäre Information A oder ihren komplementären Wert steht und die andere für die binäre Information B oder ihren komplementären Wert steht, sowie mindestens eine Schwellwertentscheidung bezüglich der aus der Mischung der zwei Ladungen resultierenden Spannung.

2. Verfahren nach Anspruch 1, **dadurch gekennzeichnet, daß** die Ladungsmischung durch Verbinden des Eingangs des Inverters 12 des Speicherpunktes Ga auf der einen Seite mit dem Eingang des Inverters I1 des Speicherpunktes Gb auf der anderen Seite realisiert wird.

3. Verfahren nach Anspruch 2, **dadurch gekennzeichnet, daß** die Verbindung durch Befehl zum Schließen der Mittel zur gesteuerten Umschaltung Tc realisiert wird.

4. Verfahren nach einem der Ansprüche 1 bis 3, **dadurch gekennzeichnet, daß** die Schwellwertentscheidung bezüglich der aus der Mischung der Ladungen resultierenden Spannung die folgenden Schritte umfaßt:

   - Versorgen mindestens eines Inverters (11, I2) mit einem niedrigen Spannungspegel,

   - Anlegen der aus der Mischung der Ladungen resultierenden Spannung an den Eingang dieses Inverters,

   - Auswerten des Ausgangs dieses Inverters, wenn die aus der Mischung der Ladungen resultierende Spannung zwischen Vmin und Vmax liegt.

5. Verfahren nach einem der Ansprüche 1 bis 3, **dadurch gekennzeichnet, daß** die Schwellwertentscheidung bezüglich der aus der Mischung der Ladungen resultierenden Spannung durch einen Inverter mit einer unteren Schwelle Vsb erfolgt, die zwischen einer minimalen Spannung, die einer logischen NULL entspricht, und der halben Summe der minimalen Spannung und einer maximalen Spannung liegt, die einer logischen EINS entspricht, dergestalt, daß für jede Spannung am Eingang dieses Inverters, die Ausgangsspannung gleich der genannten maximalen Spannung ist, falls die Eingangsspannung niedriger ist als Vsb, während sie gleich der minimalen Spannung ist, falls diese Spannung V über der Spannung Vsb liegt, oder durch einen Inverter mit einer hohen Schwelle Vsh, die zwischen der halben Summe der minimalen Spannung und der maximalen Spannung und letzterer Spannung liegt, derart, daß für jede Spannung V am Eingang dieses Inverters die Ausgangsspannung gleich ist der maximalen Spannung, falls die Eingangsspannung niedriger ist als Vsh, während sie gleich ist der minimalen Spannung, falls diese Spannung V größer ist als Vsh.

6. Verfahren nach Anspruch 5, **dadurch gekennzeichnet, daß** es mindestens zwei Schwellwertentscheidungen der aus der Mischung der Ladungen resultierenden Spannung enthält und daß diese Schwellwertentscheidungen realisiert werden durch die Inverter I2 und/oder I1, die über Mittel zur gesteuerten Umschaltung Tc verbunden sind.

7. Vorrichtung zur Verarbeitung von zwei binären Informationen A und B mit dem Ziel eine Konjunktion oder eine Disjunktion dieser Werte und/oder ihrer komplementären Werte zu erhalten, wobei die zwei binären Informationen B und A in halbstatischen Speicherpunkten Ga bzw. Gb gespeichert sind, die einem gleichen Schieberegister angehören oder nicht, jeder dieser Speicherpunkte umfaßt zwei Inverter I1, I2, die im gleichen Drehsinn angeordnet sind, wobei der Ausgang des Inverters I1 verbunden ist mit dem Eingang des Inverters I2 über Mittel zur Umschaltung (TM1, TM3) und der Ausgang des Inverters I2 verbunden ist mit dem Eingang des Inverters I1 über Mittel zur Umschaltung (TM2, TM4), wobei die Ausgangsspannung des Inverters I2 für die binäre Information des Punktes steht, **dadurch gekennzeichnet, daß** sie Mittel zur gesteuerten Umschaltung (Tc) umfaßt, die geeignet sind, den Eingang eines der Inverter (I1, I2) des Speicherpunktes Ga mit dem Eingang eines der Inverter (I1, I2) des Speicherpunktes Gb zu verbinden, und Mittel zur Schwellwertentscheidung, die mit mindestens einem der genannten Eingänge der Inverter verbunden sind.

8. Vorrichtung nach Anspruch 7, **dadurch gekennzeichnet, daß** die Mittel zur Schwellwertentscheidung durch mindestens einen der Inverter (I1, I2) gebildet sind, die untereinander über Mittel zur gesteuerten Umschaltung (Tc) verbunden sind.

9. Vorrichtung nach Anspruch 8, **dadurch gekennzeichnet, daß** der genannte wenigstens eine Inverter entweder eine untere Schwelle Vsb hat, die zwischen Tmin und der halben Summe von Tmin und Tmax liegt, dergestalt, daß für jede Spannung V am Eingang dieses Inverters, die Ausgangsspannung gleich Tmax ist, falls die Eingangsspannung niedriger ist als Vsb, während sie gleich Tmin ist, falls diese Spannung V größer ist als Vsb, oder eine obere Schwelle Vsh hat, die zwischen der halben Summe Tmin und Tmax und Tmax liegt, d.h., daß für jede Spannung V am Eingang dieses Inverters, die Ausgangsspannung gleich Tmax ist, falls die Eingangsspannung niedriger ist als Vsh, während sie gleich Tmin ist, falls diese Spannung V größer ist als Vsh.

10. Vorrichtung nach einem der Ansprüche 7 bis 9, **dadurch gekennzeichnet, daß** sie außerdem Mittel zur Invertierung I3 und Mittel zur gesteuerten Umschaltung (Ts) umfaßt, die miteinander in Serie verbunden sind und zwischen dem Ausgang eines der Inverter (I1, I2) und dem Eingang des anderen Inverters des gleichen Speicherpunktes Ga und/oder Gb angeschlossen sind, parallel zu den Mitteln zur gesteuerten Umschaltung (TM3), die die gleichen Inverter miteinander verbinden.

11. Vorrichtung nach einem der Ansprüche 7 bis 10, **dadurch gekennzeichnet, daß** sie außerdem Mittel zur gesteuerten Umschaltung (Tx) umfaßt, die zwischen dem Eingang eines der Inverter (I1, I2) eines der Speicherpunkte (Ga, Gb) und dem Eingang eines der Inverter (I1, I2) des anderen Speicherpunktes angeschlossen sind, wobei mindestens einer der genannten mit dem Mittel (Tx) verbundenen Inverter ein Inverter ist, der nicht mit den Mitteln zur gesteuerten Umschaltung (Tc) verbunden ist.

12. Vorrichtung nach einem der Ansprüche 7 bis 11, **dadurch gekennzeichnet, daß** sie mindestens einen dritten den Speicherpunkten Ga und Gb zugehörigen Speicherpunkt (Go) umfaßt.

13. Künstliche aus binären Pixeln zusammengesetzte Netzhaut, mit einem zweidimensionalen periodischen Netz zur Speicherung und Boolschen Bildverarbeitung, dessen periodische Masche gebildet wird aus einem Boolschen Prozessor, der mit mindestens einem Pixel verbunden ist, **dadurch gekennzeichnet, daß** mindestens einer dieser Boolschen Prozessoren durch eine Vorrichtung nach einem der Ansprüche 7 bis 12 gebildet wird.

FIG 1

**Fig. 2**

**Fig. 3**

Fig. 4

Fig. 5